(19) **Europäisches Patentamt / European Patent Office / Office européen des brevets**

(11) **EP 4 399 532 B1**

(12) **FASCICULE DE BREVET EUROPEEN**

(45) Date de publication et mention
de la délivrance du brevet:
**30.07.2025  Bulletin 2025/31**

(21) Numéro de dépôt: **22789249.4**

(22) Date de dépôt: **06.09.2022**

(51) Classification Internationale des Brevets (IPC):
**G01P 15/09** (2006.01)   **G01P 15/097** (2006.01)
**G01P 15/125** (2006.01)   **G01P 15/08** (2006.01)

(52) Classification Coopérative des Brevets (CPC):
**G01P 15/097; G01P 15/0922; G01P 15/125;**
G01P 2015/0814; G01P 2015/0817

(86) Numéro de dépôt international:
**PCT/FR2022/051679**

(87) Numéro de publication internationale:
**WO 2023/037070 (16.03.2023 Gazette 2023/11)**

(54) **CAPTEUR DE FORCE PRESENTANT UNE PLAGE DE FONCTIONNEMENT AUGMENTEE**

KRAFTSENSOR MIT ERWEITERTEM BETRIEBSBEREICH

FORCE SENSOR HAVING AN AUGMENTED OPERATING RANGE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité:   **09.09.2021  FR 2109457**

(43) Date de publication de la demande:
**17.07.2024  Bulletin 2024/29**

(73) Titulaire: **Commissariat à l'Energie Atomique et
aux Energies
Alternatives
75015 Paris (FR)**

(72) Inventeurs:
• **MIANI, Théo
38054 GRENOBLE CEDEX 09 (FR)**
• **JOET, Loic
38054 GRENOBLE CEDEX 09 (FR)**

(74) Mandataire: **Brevalex
Tour Trinity
1 B Place de la Défense
92400 Courbevoie (FR)**

(56) Documents cités:
**CN-A- 110 780 089**

• **BRUNO BARAZANI ET AL: "Microfabricated
Neuroaccelerometer: Integrating Sensing and
Reservoir Computing in MEMS", ARXIV.ORG,
CORNELL UNIVERSITY LIBRARY, 201 OLIN
LIBRARY CORNELL UNIVERSITY ITHACA, NY
14853, 24 March 2020 (2020-03-24),
XP081627798, DOI: 10.1109/
JMEMS.2020.2978467**
• **XIONG XINGYIN ET AL: "Using Electrostatic
Spring Softening Effect to Enhance Sensitivity of
MEMS Resonant Accelerometers", IEEE
SENSORS JOURNAL, IEEE, USA, vol. 21, no. 5,
16 November 2020 (2020-11-16), pages 5819 -
5827, XP011835841, ISSN: 1530-437X, [retrieved
on 20210204], DOI: 10.1109/JSEN.2020.3037700**
• **WU WENJIE ET AL: "Measurement of Tidal Tilt by
a Micromechanical Inertial Sensor Employing
Quasi-Zero- Stiffness Mechanism", JOURNAL
OF MICROELECTROMECHANICAL SYSTEMS,
IEEE SERVICE CENTER, US, vol. 29, no. 5, 1
October 2020 (2020-10-01), pages 1322 - 1331,
XP011813317, ISSN: 1057-7157, [retrieved on
20201005], DOI: 10.1109/JMEMS.2020.3001928**

EP 4 399 532 B1

**Description**

## DOMAINE TECHNIQUE ET ÉTAT DE LA TECHNIQUE ANTÉRIEURE

La présente invention se rapporte à un capteur de force présentant une plage de fonctionnement augmentée, et en particulier à un accéléromètre microélectromécanique résonant à plage de fonctionnement augmentée.

Un capteur de force convertit le déplacement d'un corps d'épreuve en une force qui est transmise. Dans le cas d'un capteur de force résonant, la force est transmise à une poutre résonante, le corps d'épreuve étant mis en mouvement par exemple par une accélération, un champ magnétique, une pression.

Un accéléromètre résonant est un exemple d'un capteur de force résonant comportant une masse suspendue à un support et mobile dans le plan ou dans une direction hors-plan sous l'effet d'une accélération et au moins un résonateur suspendu entre le support et la masse. Le résonateur est par exemple formé par une poutre vibrante, i.e. une poutre mise en vibration à sa fréquence de résonance par des électrodes. Lorsque la masse se déplace sous l'effet d'une accélération, la poutre qui est mécaniquement solidaire de la masse est comprimée ou étirée, ce qui modifie sa fréquence de résonance. La variation de sa fréquence de résonance est détectée, ce qui permet de remonter à la valeur de l'accélération. La poutre résonante est utilisée comme capteur de force.

L'article "Microfabricated Neuroaccelerometer: Integrating Sensing and Reservoir Computing in MEMS" de Bruno Barazani et al. décrit un accéléromètre doté de capacités de traitement intrinsèques, qui réunit les fonctions de détection et de calcul dans le même MEMS. En particulier, l'article décrit un corps d'épreuve couplé électriquement (mais non mécaniquement) à une jauge de contrainte sous la forme d'une poutre de détection vibrante.

Les accéléromètres fabriqués suivant la technologie MEMS&NEMS (Microelectromechanical systems & Nanoelectromechanical systems en terminologie anglo-saxonne) comportent une masse de dimensions micrométriques, i.e. ayant une empreinte de quelques 100 $\mu$m de côté à quelques mm de côté, par exemple formée par un carré de 1000 $\mu$m. L'épaisseur de la masse peut atteindre par exemple jusqu'à 700 $\mu$m due à l'épaisseur du substrat, et une ou des poutres résonantes ou résonateurs de dimensions nanométriques, désignés nanorésonateurs. Les nanorésonateurs sont des poutres dont les dimensions peuvent être les suivantes : une longueur de quelques $\mu$m à quelques dizaines de $\mu$m et une section nanométrique de quelques dizaines de nm à 1 $\mu$m de côté.

En miniaturisant les poutres par rapport à la masse, il est possible d'atteindre une sensibilité à l'accélération beaucoup plus importante que celle atteinte part des accéléromètres comportant une masse sismique et des poutres de taille micrométrique. Par ailleurs, la gamme dynamique d'un résonateur utilisé en tant que capteur de force est limitée par les contraintes maximums admissibles par la poutre vibrante. En compression, cette contrainte est bornée par le phénomène de flambage. En tension, la rupture du matériau de la poutre est le phénomène limitant. Dans le cadre de résonateurs nanométriques, ces limites dimensionnent la plage maximale de fonctionnement du capteur.

Par exemple, dans le cas d'une poutre en silicium, le flambage d'un résonateur nanométrique, ayant une section de 250 nm$^2$ et de 10 $\mu$m longueur, est atteint à une contrainte en compression de 300 MPa, alors que la rupture en tension a lieu pour une force de tension supérieure à 1 *GPa*. Par conséquent c'est le phénomène de flambage qui limite la plage de fonctionnement.

Or, la couche nanométrique dans laquelle est réalisée la poutre est généralement sollicitée par une contrainte interne en compression qui peut être de l'ordre de 150 MPa, cette contrainte interne apparaît lors de la fabrication. La plage de fonctionnement est alors réduite à $\pm$ 150MPa, la plage de mesure étant symétrique, voire à moins pour garder une marge de « sécurité » par rapport au flambage.

Le même phénomène peut subvenir dans le cas d'un capteur de force mettant en œuvre une ou plusieurs jauges piézorésistives.

Par conséquent la plage de fonctionnement des accéléromètres MEMS&NEMS est sensiblement réduite.

## EXPOSÉ DE L'INVENTION

C'est par conséquent un but de la présente invention d'offrir un capteur de force présentant une plage de fonctionnement étendue par rapport aux capteurs de force de l'état de la technique.

Le but énoncé ci-dessus est atteint par un capteur de force résonant comportant un corps d'épreuve de taille micrométrique et une jauge de contrainte de taille micrométrique au moins séparés mécaniquement, et des moyens électrostatiques de couplage entre la masse et la jauge de contrainte qui, d'une part, appliquent à l'état repos une sollicitation en étirement induite par une force électrostatique initiale, ce qui permet au moins d'annuler tout ou partie de la contrainte interne à la jauge de contrainte. D'autre part, ces moyens permettent lorsque le corps d'épreuve est déplacé d'appliquer une contrainte en compression ou en étirement à la jauge de contrainte tout en ayant un corps d'épreuve et une jauge de contrainte séparés mécaniquement.

La séparation mécanique permet un relâchement d'une partie des contraintes internes de la jauge de contrainte. L'application d'une contrainte en étirement, dû aux moyens électrostatiques de couplage, annule une autre partie des contraintes interne. Ainsi la plage de fonctionnement est alors étendue, de préférence au moins de la valeur des contraintes internes relâchées.

La jauge de contrainte peut être un résonateur formé par une poutre vibrante de taille nanométrique ou une jauge piézorésistive de taille nanométrique.

Avantageusement, la contrainte en étirement peut être telle que la poutre est mise en tension, ce qui augmente encore la plage de fonctionnement.

Dans un exemple de réalisation, le capteur de force comporte un chariot de masse faible relativement à celle du corps d'épreuve, qui transmet la contrainte à la jauge de contrainte via un bras de levier. Les moyens électrostatiques de couplage peuvent comporter des peignes interdigités.

C'est également un but de la présente invention d'offrir un capteur de force offrant une sensibilité augmentée. Pour cela, le capteur de force comporte deux jauges de contrainte montées en différentielle, les forces électrostatiques sont appliquées de manière équilibrée au corps d'épreuve, annulant les forces électrostatiques au repos et repoussant ainsi le « pull-in » ou risque de « collapse ». Il est alors possible d'appliquer une tension électrique plus importante et/ou de réduire les entrefers, et d'augmenter ainsi la sensibilité du capteur.

En d'autres termes, on réalise un capteur de force dans lequel le déplacement du corps d'épreuve est transmis à une jauge de contrainte par un couplage électrostatique, ce qui permet de découpler mécaniquement le corps d'épreuve de la poutre et de libérer une partie des contraintes internes de la jauge de contrainte, et ce qui permet également d'appliquer une contrainte en tension permanente à la jauge de contrainte, avantageusement au moins de la valeur de la partie des contraintes internes non relâchées par le découplage mécanique. Le couplage électrostatique permet de transmettre une contrainte en tension/compression variable à la jauge de contrainte en fonction du déplacement du corps d'épreuve.

On entend par « découplage mécanique » le fait qu'il n'y ait pas de liaison mécanique directe entre le corps d'épreuve et la jauge de contrainte, le corps d'épreuve et la poutre étant par ailleurs suspendues sur le support du capteur.

La présente invention est définie par la revendication indépendante, et des modes de réalisation avantageux sont décrits dans les revendications dépendantes.

De préférence, le capteur de force comporte une deuxième jauge de contrainte de section nanométrique montée en différentiel par rapport à la première jauge de contrainte, et des deuxièmes moyens de couplage électrostatique entre le corps d'épreuve et ladite deuxième jauge de contrainte configurés pour assurer un découplage mécanique entre ladite deuxième jauge de contrainte et le corps d'épreuve, pour qu'au repos, lesdits deuxièmes moyens de couplage électrostatique génèrent une traction sur la deuxième jauge de contrainte, et pour que sous l'effet d'une accélération modifient l'état de contrainte de la deuxième jauge de contrainte.

La première jauge de contrainte de section nanométrique est dotée d'une poutre vibrante. Cette poutre vibrante est suspendue à une poutre de suspension.

La poutre de suspension n'a pas de rôle de détection et n'est pas mise en vibration autour de sa fréquence de résonance.

La poutre vibrante a une section inférieure à la poutre de suspension.

En particulier, la poutre de suspension a une section au moins 10 fois, préférentiellement 100 fois supérieure, et plus avantageusement 1000 supérieure à celle de la poutre vibrante.

La poutre de suspension a quant à elle une section micrométrique comprise entre 1μm et plusieurs centaines de micromètres.

La poutre de suspension permet de libérer les contraintes internes résultant de la fabrication de la couche dans laquelle est gravée la poutre vibrante. Elle participe ainsi à l'extension de la plage de fonctionnement.

Les premiers et/ou deuxièmes moyens de couplage électrostatique peuvent être configurés pour générer, au repos, une force électrostatique de sorte à au moins annuler les contraintes résiduelles dans la première jauge de contrainte et/ou la deuxième jauge de contrainte.

Dans un exemple de réalisation, les premiers et/ou deuxièmes moyens de couplage électrostatique comportent chacun au moins première et une deuxième électrode en regard, la première électrode étant solidaire en mouvement de la masse sismique et la deuxième électrode étant fixée à une extrémité longitudinale de la première et/ou de la deuxième jauge de contrainte.

La première jauge de contrainte et/ou la deuxième jauge de contrainte peut ou peuvent être reliée(s) chacune à une deuxième électrode par un bras de levier articulé en rotation dans le plan du capteur.

Les premiers et/ou deuxièmes moyens de couplage électrostatique comportent par exemple chacun au moins une paire de peignes interdigités munis de doigts, un peigne étant solidaire en mouvement du corps d'épreuve et l'autre étant fixé au bras de levier.

Le corps d'épreuve et les moyens de suspension du corps d'épreuve sont configurés pour que le corps d'épreuve se déplace en translation dans le plan le long d'une direction donnée.

Selon une caractéristique additionnelle, Les premiers et/ou les deuxièmes moyens de couplage électrostatique comportent au moins un chariot portant au moins un peigne et connecté mécaniquement au bras de levier. De préférence, le chariot a une masse réduite par rapport à celle du corps d'épreuve, la masse du chariot étant au moins 10 fois inférieure à la masse du corps d'épreuve.

Par exemple, le chariot comporte un cadre extérieur délimité par des montants desquels des doigts du peigne font saillie, et le au moins un peigne solidaire en mouvement du corps d'épreuve est disposé à l'intérieur du cadre et ses doigts sont placés entre les doigts du peigne du chariot.

Avantageusement, le capteur de force comporte plusieurs paires de peignes interdigités de sorte à offrir une surface de couplage électrostatique importante.

Par exemple, les premiers et/ou deuxièmes moyens de couplage comportent deux chariots reliés chacun à la première jauge de contrainte par un bras de levier et une transmission reliée aux deux bras de levier.

Selon un autre exemple, la première et/ou la deuxième jauge de contrainte est et/ou sont suspendue(s) par une extrémité longitudinale à une première face latérale d'une poutre de suspension déformable en flexion dans la direction donnée (X), et une deuxième face de la poutre de suspension opposée à la première face est en regard avec un bord du corps d'épreuve formant avec celui-ci les premier et/ou les deuxièmes moyens de couplage électrostatique.

Selon un autre exemple, le capteur de force comporte une articulation pivot par laquelle la masse est suspendue au support et au moyen de laquelle la masse est mobile en rotation dans le plan du capteur de force, et les premiers et/ou les deuxièmes moyens de couplage sont formés par une face latérale du bras de levier et un bord en regard du corps d'épreuve.

Très avantageusement, ladite au moins un jauge de contrainte est un résonateur à poutre vibrante.

Un autre objet de la présente demande est un accéléromètre comportant un capteur de force selon l'invention, dans lequel le corps d'épreuve est une masse sismique Un autre objet de la présente demande est un gravimètre comportant au moins un accéléromètre selon l'invention et les moyens de suspension de la masse sismique sont configurés pour flamber lorsque la masse sismique est soumise au 1g de l'accélération terrestre.

## BRÈVE DESCRIPTION DES DESSINS

La présente invention sera mieux comprise sur la base de la description qui va suivre et des dessins en annexe sur lesquels :

Figure 1A est une représentation schématique d'un exemple d'accéléromètre selon l'invention selon un premier mode de réalisation.

Figure 1B est une représentation de l'accéléromètre de la figure 1A lorsqu'une force électrostatique est générée avec une vue agrandie.

Figure 2 est une représentation schématique d'un autre exemple d'accéléromètre selon l'invention selon un premier mode de réalisation.

Figure 3A est une représentation schématique d'un exemple d'accéléromètre selon l'invention selon un deuxième mode de réalisation.

Figure 3B est une vue agrandie de la figure 3A.

Figure 4A est une représentation schématique d'un autre exemple d'accéléromètre selon l'invention selon le deuxième mode de réalisation.

Figure 4B

Figure 4C

Figure 4D

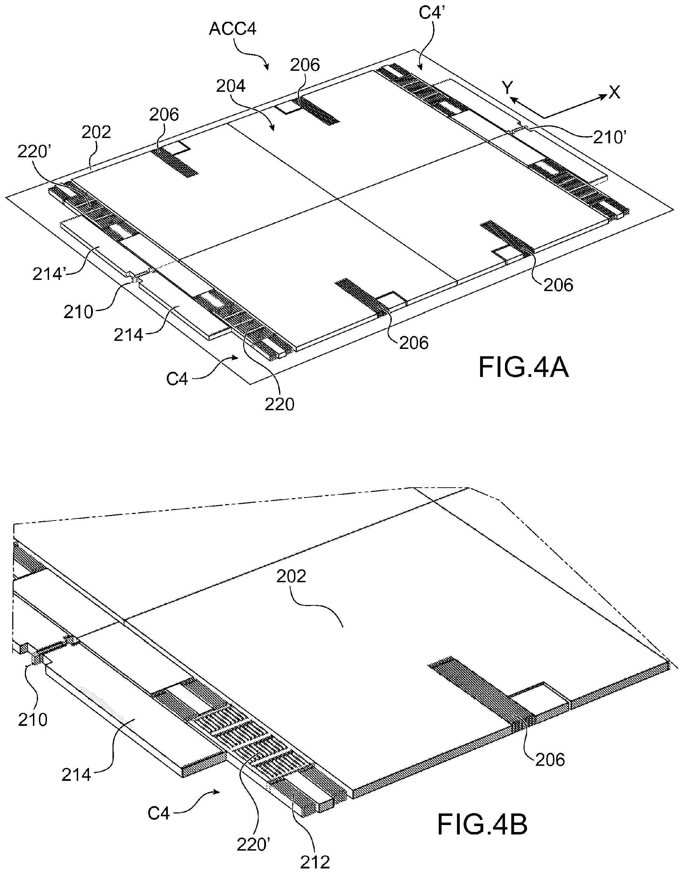

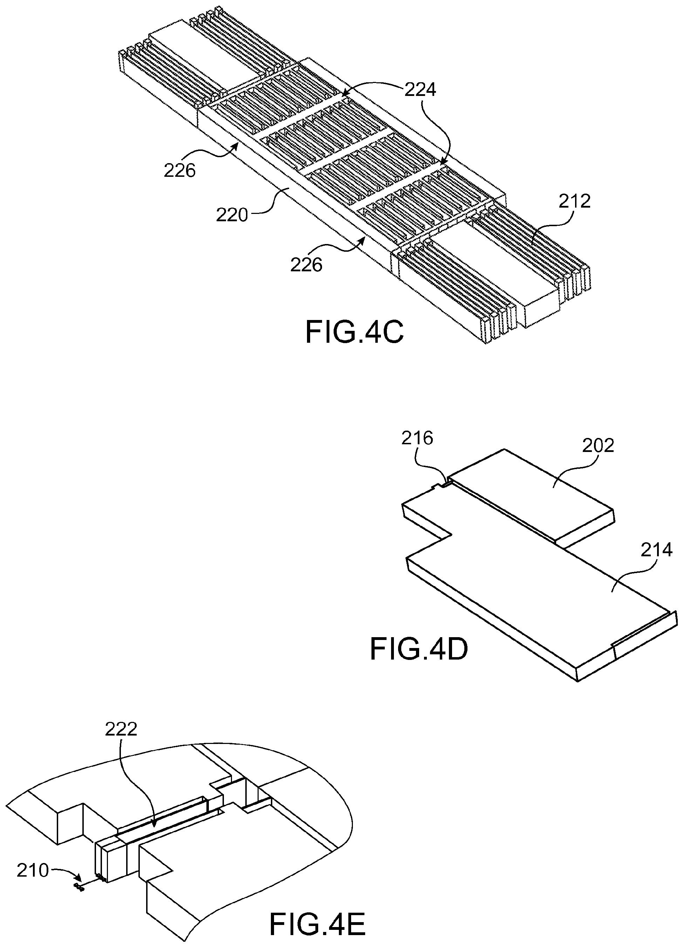

Figure 4E sont des vues de détail de l'accéléromètre de la figure 4A.

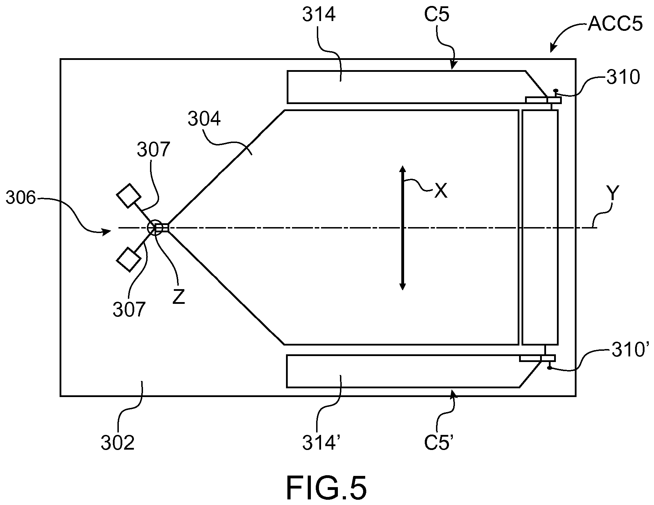

Figure 5 est une représentation schématique d'un accéléromètre selon l'invention selon un troisième mode de réalisation.

## EXPOSÉ DÉTAILLÉ DE MODES DE RÉALISATION PARTICULIERS

Le capteur de force selon l'invention sera décrit plus particulièrement dans son application à un accéléromètre microélectromécanique, mais celui-ci peut mis en œuvre dans d'autres applications comme cela sera décrit ci-dessous.

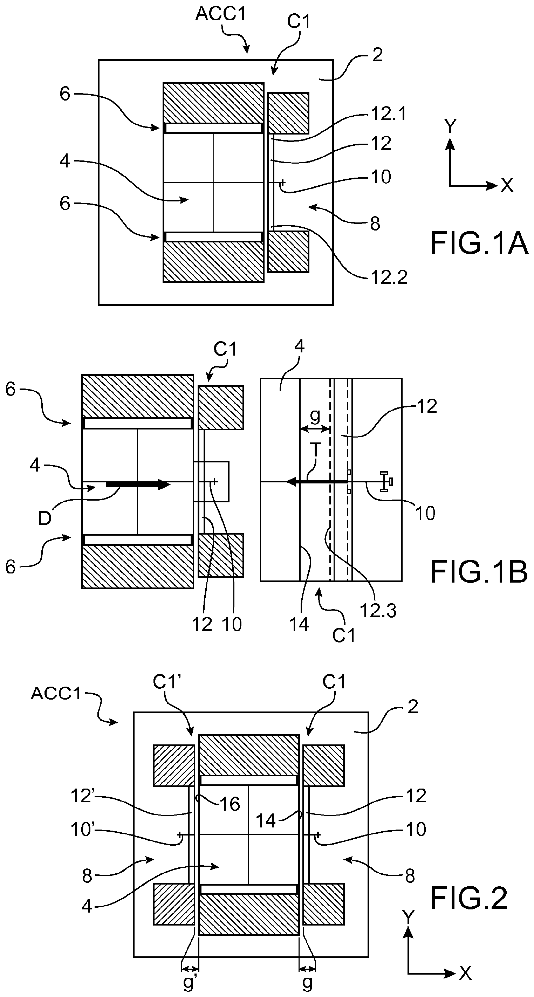

Sur les figures 1A et 1B, on peut voir un exemple de réalisation d'un accéléromètre microélectromécanique ACC1 selon un premier mode de réalisation.

Dans la présente demande on entend par « accéléromètre microélectromécanique » un accéléromètre microélectromécanique et nanoélectromécanique comportant une partie notamment la masse sismique de dimensions micrométriques et une autre partie, notamment les moyens de mesure, de dimensions nanométriques.

L'accéléromètre ACC1 comporte un support 2, qui est généralement désigné substrat en microélectronique, une masse sismique 4 suspendue au support 2 par des moyens de suspension 6. Les moyens de suspension 6 sont tels que la masse sismique 4 est apte à se déplacer dans le plan XY de l'accéléromètre le long de la direction X sous l'effet d'une accélération.

Le plan de l'accéléromètre est un plan parallèle au support.

Dans l'exemple représenté, les moyens de suspension 6 comportent des poutres s'étendant perpendiculairement à la direction X dans le plan de l'accéléromètre et configurées pour se déformer en flexion dans la direction X. Dans cet exemple, la masse sismique 4 est de forme carrée et les poutres sont au nombre de quatre, parallèles entre elles et relient un sommet de la masse 4 au support 2. D'autres moyens de suspension et d'autre disposition sont envisageables. Par exemple, les poutres peuvent être repliées de sorte à diminuer la raideur dans la direction X tout en limitant le flambage des éléments de suspensions. Plus au moins de quatre éléments de suspension sont envisageables, par exemple six éléments de suspension peuvent être mis en œuvre. De préférences, les moyens de suspension sont symétriques pour rejeter au maximum les mouvements parasites, notamment la rotation de la masse dans le plan.

En outre la forme de la masse n'est pas limitative.

Dans cet exemple, l'accéléromètre comporte en outre des moyens de mesure 8 du déplacement de la masse sismique comprenant une poutre vibrante 10. Une poutre vibrante ou poutre résonante est mise en vibration à sa fréquence de résonance par une ou plusieurs électrodes d'actionnement, toute contrainte en traction ou compression subie pas la poutre se traduit par une variation de sa fréquence de résonance, cette variation permet d'en déduire la contrainte subie. La suspension de la poutre vibrante est telle que la poutre est apte à vibrer. La poutre vibrante 10 est parallèle à la direction X et est suspendue par une extrémité longitudinale au support 2 et par une autre extrémité longitudinale à une poutre de suspension 12 qui est perpendiculaire à la direction X, la poutre de suspension 12 étant ancrée au support par ses extrémités 12.1, 12.2. La poutre de suspension 12 est apte à se déformer en flexion dans la direction X. La poutre vibrante 10 peut être ancrée directement à un plot. Les moyens de mesure comportent alors des moyens de détection capacitive. De préférence, l'électrode de détection est distincte de l'électrode d'actionnement. Dans un autre exemple, les moyens de détection sont de type piézorésistif et l'extrémité de la poutre vibrante 10 est reliée à un plot via une jauge piézorésistive.

L'accéléromètre est un système MEMS&NEMS (Microelectromechanical systems & Nanoelectromechanical systems en terminologie anglo-saxonne) ou systèmes microélectromécanique et nanoélectromécaniques. L'accéléromètre comporte alors une masse de taille micrométrique, i.e. ayant une empreinte de quelques 100 $\mu$m de côté à quelques mm de côté, par exemple formée par un carré de 1000 $\mu$m. L'épaisseur de la masse peut atteindre par exemple jusqu'à 700 $\mu$m due à l'épaisseur du substrat, et des moyens de mesure de taille nanométrique, i.e. la poutre vibrante peut avoir les dimensions suivantes : une longueur de quelques $\mu$m à quelques dizaines de $\mu$m et une section nanométrique de quelques dizaines de nm à 1 $\mu$m de côté, par exemple 250 nm. L'accéléromètre ACC1 est fabriqué par les technologies de la microélectronique par dépôt de couches et gravure, la poutre vibrante 10 est gravée dans une couche dont l'épaisseur est de quelques dizaines à quelques centaines de nanomètres. Cette couche est sollicitée par une contrainte interne en compression, par exemple de l'ordre de 150 MPa.

Dans l'accéléromètre ACC1 des figures 1A et 1B la poutre de suspension 12, à laquelle est suspendue la poutre vibrante 10, est libre de se déformer dans la direction X qui est la direction longitudinale de la poutre vibrante 10, les contraintes internes résultant de la fabrication de la couche dans laquelle est gravée la poutre vibrante 10 sont en partie relâchées.

L'accéléromètre ACC1 comporte également des premiers moyens électrostatiques C1 assurant un couplage entre la masse sismique 4 et la poutre vibrante 10.

Les premiers moyens de couplage C1 comportent un condensateur à capacité variable formé par un côté 14 de la masse sismique 2 et par une face latérale 12.3 de la poutre de suspension 12. Le côté 14 et la face latérale 12.3 sont en regard et séparés d'un entrefer g, ils forment les plaques du condensateur à capacité variable.

En appliquant une différence de potentiel entre la masse sismique 2 et la poutre de suspension 12, une force électrostatique apparaît entre le côté 14 et la face latérale 12.3, qui assure un couplage entre la masse sismique 4 et la poutre vibrante.

Ce couplage se traduit :

- au repos; d'une part, par le fait qu'il y a une attraction entre la masse et la poutre de suspension 12, ce qui déforme la poutre de suspension 12 en flexion en direction de la masse sismique 4 et réduit l'entrefer entre la masse et la poutre de suspension 12, exerçant un effort de traction sur la poutre vibrante 10. Cet effort de traction a pour effet d'annuler au moins une partie des contraintes internes restantes dans la poutre vibrante 10. La différence de potentiel est de préférence choisie pour au moins annuler complètement les contraintes internes.

- dans un état sous accélération d'autre part, par le fait qu'un déplacement de la masse sismique dans la direction X, sous l'effet d'une accélération selon cet axe, déforme la poutre de suspension 12 en flexion et applique une contrainte en traction ou étirement à la poutre vibrante 10. Il est possible de mesurer l'accélération via la contrainte appliquée à la poutre vibrante 10. En effet, la force électrostatique étant inversement proportionnelle au carré de la valeur de l'entrefer, lorsque la masse sous l'effet d'une accélération est déplacée vers la poutre de suspension 12, la valeur de l'entrefer se réduit et la force de traction appliquée à la poutre vibrante augmente. Sur la figure 1B, le déplacement de la masse sismique 4 est symbolisé par la flèche D. On peut voir les poutres des moyens de suspension qui sont déformés. Sur la figure 1B, la flèche T symbolise la force de traction exercée sur la poutre vibrante 10 au niveau de son extrémité connectée à la poutre de suspension 12, par la force électrostatique.

En annulant les contraintes internes à la poutre vibrante 10, la limite de fonctionnement en compression est décalée de la valeur des contraintes internes, par exemple 150 MPa. Pour une poutre de section de 250 nm$^2$ et de 10 $\mu$m de long, la limite de flambage est de 300 MPa. Ainsi la plage de fonctionnement au lieu d'être réduite à +/-50 MPa du fait des contraintes internes, s'étend sur +/- 200 MPa si toutes les contraintes internes sont relâchées.

Dans un mode de fonctionnement, on peut choisir d'appliquer une différence de potentiel entre la masse et la poutre de suspension 12 telle que l'effort de traction vu par la poutre vibrante 10 soit supérieure aux contraintes internes à relâcher. On augmente davantage la plage de fonctionnement. Il est à noter que la rupture théorique en tension pour le silicium est supérieure à 1 GPa, le niveau de l'effort de traction applicable à la poutre est donc élevé.

Le fonctionnement de l'accéléromètre ACC1 est le suivant.

Au repos, une différence de potentiel entre la masse 4 et la poutre de suspension 12 permet de relâcher tout ou partie des contraintes internes à la poutre vibrante.

Lorsque la masse sismique 4 se déplace dans la direction X sous l'effet d'une accélération, du fait du couplage électrostatique entre la masse et la poutre de suspension 12, le déplacement de la masse sismique applique une traction sur la poutre vibrante 10. La poutre vibrante 10 est par ailleurs mise en vibration à sa fréquence de résonance Cette traction a pour effet de faire varier la fréquence de résonance de la poutre. Une unité de traitement à laquelle est connecté l'accéléromètre mesure la variation de fréquence de résonance, détermine le déplacement de la masse et calcule à l'accélération qu'elle a subie.

Sur la figure 2, on peut voir un autre exemple de réalisation d'un accéléromètre ACC2 selon le premier mode de réalisation.

L'accéléromètre ACC2 diffère de l'accéléromètre ACC1 en ce qu'il comporte une deuxième poutre vibrante 10' montée en différentielle avec la poutre vibrante 10.

La poutre vibrante 10' est disposée à l'opposé de la poutre vibrante 10 par rapport à la masse sismique. La poutre vibrante 10' s'étend le long de la direction X et est suspendue par une extrémité longitudinale au support 2 et est suspendue par une autre extrémité longitudinale à une poutre de suspension 12' s'étendant perpendiculairement à la direction X et apte à se déformer en flexion. La poutre de suspension 12' est ancrée au support par ses deux extrémités longitudinales.

La poutre de suspension 12' s'étend parallèlement à un bord 16 de la masse 4 parallèle au bord 14. Le bord 16 forme avec le bord latéral de la poutre de suspension 12' un condensateur à capacité variable d'entrefer g', formant des deuxièmes moyens de couplage électrostatique C1' assurant un couplage entre la masse sismique 2 et la poutre vibrante 10'. Comme pour la poutre vibrante 10, la connexion de l'une des extrémités de la poutre vibrante 10' à la poutre de suspension 12' permet de relâcher une partie des contraintes internes à la poutre 10'.

Par ailleurs, l'application d'une différence de potentiel entre la masse et la poutre vibrante 10' génère des forces électrostatiques exerçant un effort de traction sur la poutre vibrante 10' et donc l'annulation au moins partielle, et de préférence totale, des contraintes internes.

La mise en œuvre d'un montage différentiel et de deux moyens de couplage C1, C1' permet très avantageusement d'augmenter la sensibilité de l'accéléromètre, qui est inversement proportionnelle au cube de la largeur des entrefers et proportionnelle au carré de la tension de polarisation. En effet, puisque les forces électrostatiques s'appliquent sur les faces opposées 14 et 16 de la masse 4, la masse 4 est maintenue en équilibre entre les deux poutres de suspension 12, 12'. Il est alors possible d'augmenter les forces électrostatiques entre la masse 4 et les poutres 12 et 12' en augmentant la différence de potentiel appliquée, et ainsi de réduire la largeur des entrefers tout en limitant les risques de collage entre la masse et les poutres. Des entrefers de largeur réduite et une tension supérieure permettent d'atteindre une sensibilité élevée.

Le fonctionnement de l'accéléromètre ACC2 est le suivant :

Le mouvement de la masse sismique sous l'effet de l'accélération fait varier les entrefers g et g' de façon différentielle. Par exemple, lorsque la masse 4 se déplace vers la poutre vibrante 10, la largeur de l'entrefer g diminue, la force électrostatique s'appliquant augmente, ce qui amplifie la contrainte en tension sur la poutre vibrante 10; la largeur de l'entrefer g' augmente, réduisant la force électrostatique et réduisant la contrainte en tension sur la poutre vibrante 10'.

Ces variations de contrainte en tension font varier les fréquences de résonance de chacune des poutres vibrantes 10, 10', ce qui permet de remonter à l'accélération subie par la masse.

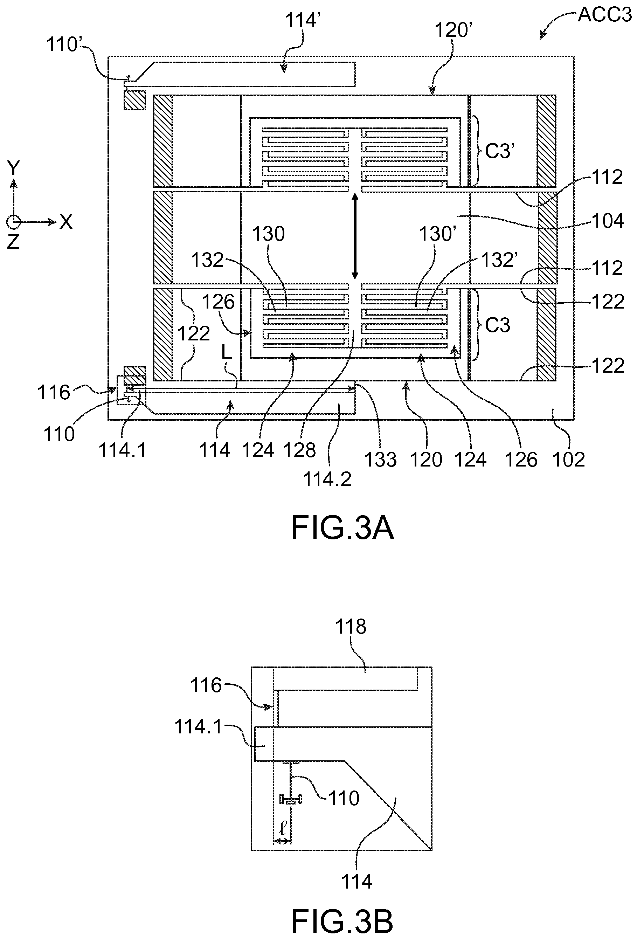

Sur les figures 3A et 3B, on peut voir un exemple de réalisation d'un accéléromètre ACC3 selon un deuxième mode de réalisation.

L'accéléromètre ACC3 se distingue des accéléromètres ACC1 et ACC2, notamment en ce qu'il met en œuvre des bras de levier.

L'accéléromètre ACC3 comporte un support 102, une masse sismique 104 suspendue au support 102 par des moyens de suspension 112. Dans l'exemple représenté, il s'agit de poutres déformables en flexion et assurant un guidage en translation de la masse sismique le long de la direction Y, similaires à celles des accéléromètres ACC1 et ACC2. Dans cet exemple la masse sismique 104 est de forme rectangulaire et deux poutres 112 s'étendent de chaque côté de la masse parallèle à la direction X.

L'accéléromètre ACC3 comporte des moyens de mesure du déplacement de la masse comportant deux poutres vibrantes 110, 110' montées en différentielle et des moyens de couplage électrostatique C3, C3' entre les moyens de mesure et la masse 104.

Chaque poutre vibrante 110, 110' est suspendue par une extrémité au support 102 et est suspendue par une autre extrémité à une poutre rigide 114, 114' des moyens de couplage C3, C3', ladite poutre rigide 114, 114' étant articulée en rotation par rapport au support 102 autour d'un axe orthogonal Z au plan de l'accéléromètre. Les poutres rigides forment des bras de levier.

Les moyens de couplage étant similaires ou identiques, seuls les moyens de couplage C3 seront décrits en détail.

Une articulation pivot 116 est prévue entre une extrémité longitudinale 114.1 de la poutre rigide 114 et le support 102. Comme on peut le voir en détail sur la figure 3B, dans cet exemple la liaison pivot 116 est formée par une poutre déformable en flexion reliant l'extrémité 114.1 de la poutre à un plot d'ancrage 118.

La poutre vibrante 110 est suspendue à la poutre rigide 114 à une distance I de la liaison pivot 116 le long de la poutre 114. Le bras de levier 114 a une longueur L. La poutre vibrante 110 est située de sorte, qu'au repos sous l'action des moyens de couplage C3, la poutre vibrante 110 subisse un effort de traction. Dans cet exemple, la poutre vibrante 110 est située à l'opposé de la liaison pivot par rapport à la poutre 114.

Les moyens de couplage électrostatique C3 comportent également un chariot 120 suspendu au support 102 et guidé en translation le long de la direction X. Dans l'exemple représenté, les moyens de suspension formés par des poutres 122 déformables en flexion assurent le guidage en translation du chariot 120 le long de la direction X. Dans l'exemple représenté, le chariot 120 a une forme extérieure rectangulaire et deux poutres 122 s'étendent de deux côtés opposés du chariot parallèles à la direction X. Le chariot est solidarisé à l'extrémité 114.2 du bras de levier 114, qui est opposée à celle 114.1 articulée sur le support.

Les moyens de couplage électrostatique comportent deux paires de peignes interdigités 124, 124', 126, 126'; une paire de peignes 124, 124' est solidaire de la masse sismique 104 et l'autre paire de peignes 126, 126' est solidaire du chariot 120. Les peignes sont orientés de sorte que, lorsque des forces électrostatiques sont générées entre les peignes, un déplacement dans la direction X est généré entre la masse 104 et le chariot 120.

Dans l'exemple représenté, un bras 128 s'étend le long de la direction Y à partir d'un bord de la masse perpendiculaire à la direction X, et porte des doigts 130 s'étendant selon la direction X de part et d'autre du bras 128. Ces doigts définissent les peignes 124, 124' de part et d'autre du bras 128.

Les peignes 126, 126' sont intégrés au chariot et se situe à l'intérieur du chariot. Le chariot comporte un cadre extérieur et des doigts 132, 132' s'étendent des bords du cadre parallèles à la direction Y définissant un peigne 126, 126' sur chaque bord du cadre.

Les doigts 130, 130' des peignes 124, 124' se logent entre les doigts 132, 132' Des entrefers variables dans la direction Y sont délimités entre une face d'un doigt 130 et une face en regard d'un doigt 132. Le chariot est connecté à l'autre extrémité 114.2 de la poutre rigide 114 par une poutre 133 présentant une rigidité dans la direction Y tout en autorisant la cohabitation entre une translation du chariot et une rotation du bras de levier

Dans cet exemple, les distances entre doigts 130, 132 et entre les doigts 130', 132' sont telles qu'elles sont minimales de sorte que les forces électrostatiques provoquent un déplacement positif du chariot 120 dans la direction Y et un déplacement négatif du chariot 120' dans la direction Y. la masse 104 étant équilibrée par les deux étapes électrostatiques.

La position de la poutre vibrante 110 par rapport au pivot 116 détermine si le mouvement du chariot induit une élongation ou une compression de la poutre 110. Dans l'exemple, la force (dans la direction positive de Y) générée par le chariot 120 induit une élongation de la poutre 110.

Les moyens de couplage C3' comportent un deuxième chariot 120' formant avec un deuxième peigne solidaire de la masse sismique des deuxièmes moyens de couplage électrostatique entre la masse et la poutre vibrante 110'.

Les chariots sont rigides ont de préférence une masse très faible par rapport à celle de la masse sismique, par exemple le rapport entre la masse d'un chariot et celle de la masse sismique est de l'ordre de 1/10, de préférence 1/20. L'intégration des peignes à l'intérieur du contour des chariots permet d'atteindre une grande compacité, mais également de réduire la masse des chariots.

La mise en œuvre de peignes interdigités permet d'obtenir une grande surface de couplage entre la masse sismique et chaque chariot, ce qui permet d'augmenter la sensibilité électrostatique, c'est-à-dire la sensibilité entre le mouvement de la masse et la force électrostatique générée. En effet cette sensibilité est proportionnelle à la capacité de couplage, donc à sa surface.

La force électrostatique attirant les deux électrodes d'une capacité est la suivante :

$$Force = \frac{1}{2} \frac{C}{g} V_{pol}^2$$

Avec C la capacité et g la distance entre les surfaces en regard.

La capacité est donnée par les surfaces S en regard, la permittivité $\varepsilon_0$ et l'entrefer g :

$$C = \varepsilon_0 \frac{S}{g}$$

La disposition des peignes interdigités n'est pas limitative, par exemple le bras 128 portant les peignes pourrait être porté par le chariot et la masse comporterait des peignes disposés de part et d'autre de l'arbre. En outre le nombre de doigts de peignes n'est pas non plus limitatif.

Les poutres vibrantes voient une partie de leurs contraintes internes relâchées grâce à la mobilité de l'ensemble bras de levier 114, 114' et chariot 120, 120' par rapport à la masse sismique. En outre en appliquant une différence de potentiel entre la masse sismique et les chariots, une force électrostatique est générée entre les doigts des peignes interdigités, les chariots sont attirés vers la masse sismique, ce qui fait pivoter les bras de levier 114, qui appliquent un effort de traction aux poutres vibrantes, ce qui permet d'annuler tout ou partie des contraintes internes non relâchées, voire de placer les poutres vibrantes de sorte qu'elles soient toujours en état d'étirement pendant les mesures.

En variante les entrefers entre doigts de la masse et des chariots 120 et 120' sont disposés de sorte que le chariot 120 se déplace négativement dans la direction Y et le chariot 120' se déplace positivement dans la direction Y. L'emplacement des poutres vibrantes est choisi par rapport au levier de sorte qu'elles subissent encore un effort de traction.

Le fonctionnement de l'accéléromètre ACC3 va maintenant être décrit.

La masse sismique se déplace le long de la direction Y sous l'effet d'une accélération, ce qui fait varier les entrefers entre les peignes portés par la masse 104 et ceux portés par les chariots 120, 120' de façon différentielle. Par exemple, une réduction de la largeur des entrefers avec le chariot 120 augmente la force électrostatique s'appliquant et amplifie la contrainte en tension sur la poutre vibrante 110, et une augmentation de la largeur des entrefers avec le chariot 120' réduit la force électrostatique et réduit la contrainte en tension sur l'autre poutre vibrante 110'.

Ces variations de contrainte en tension font varier les fréquences de résonance de chacune des poutres résonantes 110, 110', ce qui permet de remonter au déplacement de la masse et à l'accélération à l'origine de ce déplacement. Suivant les contraintes en tension appliquées aux poutres vibrantes à l'état repos, l'une des poutres passe dans un état de compression ou reste en tension, mais sous une tension réduite.

La contrainte de flambage n'est plus limitante du fait de l'application de la force électrostatique au repos. C'est le déplacement maximal de la masse avant instabilité qui limite la gamme dynamique. Or la contrainte dans la poutre vibrante équivalente au déplacement de la masse est supérieure à la contrainte de flambage dans un accéléromètre résonant de l'état de la technique, il en résulte donc une augmentation de la gamme dynamique.

Un accéléromètre similaire à l'accéléromètre ACC3 ne comportant qu'une poutre vibrante et qu'un chariot ne sort pas du cadre de la présente invention.

Sur les figures 4A à 4E, on peut voir un exemple d'accéléromètre ACC4 selon le deuxième mode de réalisation.

De manière similaire à l'accéléromètre ACC3, l'accéléromètre ACC4 met en œuvre des chariots et des peignes interdigités formant les moyens de couplage électrostatique. Dans cet exemple, la masse 204 est suspendue par des moyens de suspension 206 formés par une lame déformable en flexion dans le plan XY et repliée sur elle-même, désignée également ressort "folding". Ces moyens de suspension assurent également le guidage de la masse le long de la direction X.

Les moyens de mesure comportent deux poutres vibrantes 210, 210' montées en différentielle.

Les moyens de couplage électrostatique C4, C4'sont similaires pour les deux poutres vibrantes, seuls les moyens de couplage C4 couplant la poutre vibrante 210 à la masse 204 seront décrits en détail.

Les moyens de couplage C4 comportent deux chariots 220, 220', chaque chariot est suspendu au support 202 et guidé en translation le long de la direction X par des moyens de suspension 212 similaires aux moyens de suspension de la masse. Dans l'exemple représenté, quatre ressorts sont mis en œuvre.

Seul le chariot 220 sera décrit en détail ; celui-ci est plus particulièrement visible sur la figure 4C. Le chariot 220 comporte deux paires de peignes 226, coopérant avec les peignes 224 solidaires de la masse 204. Les peignes 224, 226 sont orientés de sorte à exercer un effort dans la direction X. Les doigts de tous les peignes sont parallèles et les peignes sont interdigités deux à deux.

Le chariot 220 a une masse très faible relativement à celle de la masse sismique 204, ceci peut être avantageusement obtenu grâce à l'intégration des peignes dans les chariots et à la structure relativement évidée des chariots.

Chaque chariot 220 est relié à la poutre vibrante 210 par un bras de levier 214 formé par une poutre articulée en rotation sur le support 202 par une liaison pivot 216 (figure 4D). Chaque chariot 220 est connecté à une extrémité longitudinale du bras de levier 214 et la poutre vibrante 210 est connectée à l'autre extrémité du bras de levier 214 et la liaison pivot 216 est située entre les deux extrémités. Dans cet exemple la poutre vibrante 210 est connectée aux extrémités longitudinales en regard du bras de levier connecté au chariot 220 et au bras de levier connecté au chariot 220'. La connexion est réalisée dans l'exemple représenté par une transmission 222 en forme de U, chaque extrémité des branches du U étant fixée sur une extrémité longitudinale d'un bras de levier, et la poutre vibrante 210 et connectée au fond du U (figure 4E).

Les bras de levier 214, 214' et les chariots étant découplés structurellement de la masse, une partie des contraintes interne des poutres vibrantes peut être relâchée. Par ailleurs, en appliquant une différence de potentiel entre la masse sismique 204 et les chariots 220, 220', les chariots 220, 220' se rapprochent de la masse sismique provoquant la rotation des bras de levier et l'application d'un effort de traction sur la poutre vibrante 210 via la transmission. Cet effort est de préférence tel qu'il annule l'autre partie des contraintes internes, voire qu'il met en tension la poutre vibrante.

Le même phénomène se produit sur la poutre vibrante 210' grâce aux moyens de couplage C4'.

Un accéléromètre similaire à l'accéléromètre ACC4 ne comportant qu'une poutre vibrante et qu'un chariot ne sort pas du cadre de la présente invention.

Le fonctionnement de l'accéléromètre ACC4 est similaire à celui de l'accéléromètre ACC3. Sur la figure 5, on peut voir un exemple de réalisation d'un accéléromètre ACC5 selon un troisième mode de réalisation.

L'accéléromètre ACC5 diffère des autres modes de réalisation en ce que la masse sismique 304 est montée mobile en rotation autour d'un axe Z normal au plan de l'accéléromètre.

La masse 304 est suspendue par rapport au support 302 par une articulation pivot 306. Dans cet exemple, l'articulation pivot comporte deux poutres 307 chacune ancrée par une extrémité à un plot d'ancrage du support et fixées par une autre extrémité à la masse sismique 304. Les poutres 307 se connectent à la masse sismique 304 en un même point par lequel passe l'axe de rotation Z. Dans cet exemple la forme de la masse sismique 304 est définie par un assemblage d'un carré et d'un triangle isocèle, la base du triangle isocèle étant confondue avec un côté du carré. Les poutres 307 de l'articulation pivot se connectent à la masse sismique 304 au sommet du triangle isocèle.

L'accéléromètre comporte également des moyens de mesure dans l'exemple il comporte deux poutres vibrantes 310, 310' montées en différentielle et des moyens de couplage électrostatique C5, C5'.

Les moyens de couplage électrostatique C5, C5' sont similaires à ceux des accéléromètres ACC3 et ACC4, ils mettent en œuvre deux bras de levier 314, 314' articulés en rotation sur le support et en couplage électrostatique avec la masse sismique 304

Dans cet exemple, le couplage est réalisé directement entre une face latérale du bras de levier 314, 314' et un côté de la masse sismique 304. Dans l'exemple représenté, il s'agit d'un côté du carré.

La masse présente un axe de symétrie Y intersectant l'axe de rotation Z.

Les bras de levier 314, 314' sont disposés symétriquement de part et d'autre de la masse sismique par rapport à l'axe Y. En disposant l'axe de rotation de la masse et les axes de rotation des bras de levier du même côté, les faces en regard des entrefers restent sensiblement parallèles.

Comme pour l'accéléromètre ACC4, l'articulation de chaque bras de levier 314, 314' est située entre la poutre vibrante 310, 310' et la zone de couplage électrostatique et la poutre vibrante 310, 310' est disposée à l'opposé de l'articulation pivot par rapport au bras de levier. En variante les emplacements de l'articulation de chaque bras de levier et celui du résonateur peuvent être inversés.

Lorsqu'une différence de potentiel est appliquée entre la masse sismique et les bras de levier, les bras de levier se rapprochent de la masse sismique dans la direction X appliquant un effort de traction aux poutres vibrantes 310, 310', ce qui permet de réduire, voire d'annuler les contraintes internes, en partie relâchées par ailleurs du fait de la structure de l'accéléromètre.

Le fonctionnement de l'accéléromètre ACC5 est similaire à celui des accéléromètres décrits ci-dessus.

La mise en œuvre d'une masse sismique mobile en rotation permet avantageusement de s'affranchir des pertes liées au guidage en translation des chariots des moyens de couplage électrostatique 1/D.

Dans les exemples décrit ci-dessus, les peignes électrostatiques interdigités sont mis en œuvre avec un bras de levier. Il sera compris qu'une configuration dans laquelle le chariot muni de peignes électrostatiques s'interdigitant avec les peignes de la masse et dans laquelle le chariot est directement relié à la poutre résonante ne sort pas du cadre de la présente invention.

L'accéléromètre selon la présente invention est particulièrement adapté pour une application en tant que gravimètre.

En effet, en gravimétrie un accéléromètre est soumis à l'accélération de la pesanteur (1g) et mesure les faibles déplacements de la masse sismique autour de ce point d'équilibre, représentant entre autres les fluctuations de la gravité terrestre. Pour mesurer de tels déplacements, l'accéléromètre requiert une grande sensibilité. Il existe un gravimètre mettant en œuvre une détection capacitive et des moyens de suspension de la masse sismique de raideur infiniment basse, les charnières sont conçues de façon à flamber lorsque la masse sismique est soumise au 1g de l'accélération terrestre. Un tel gravimètre est décrit dans le document W. Wu et al., "Measurement of Tidal Tilt by a Micromechanical Inertial Sensor Employing Quasi-Zero- Stiffness Mechanism," J. MICROELECTROMECHANICAL Syst., vol. 29, no. 5, p. 10, 2020.

Grâce à la présente invention, il est possible de réaliser un gravimètre mettant en œuvre une détection à poutre vibrante de section nanométrique présentant une sensibilité augmentée par rapport à la détection capacitive, tout en n'altérant pas la raideur infiniment basse des moyens de suspension, et ceci grâce à la mise en œuvre des moyens de couplage électrostatique qui permettent de découpler mécaniquement la masse des poutres vibrantes. La mise en œuvre de moyens de couplage électrostatique est d'autant plus intéressante que la force électrostatique dépend du carré de la variation d'entrefer, donc du déplacement de la masse sismique.

Le gravimètre comporte un accéléromètre selon l'invention, présentant des moyens de mesure différentielle et des moyens de suspension dont les dimensions ont été calculées pour flamber lorsque la masse sismique est soumise au 1g de l'accélération terrestre. Le flambement a lieu dans une direction contenue dans le plan de l'accéléromètre, i.e. dans la direction de déplacement de la masse. Les moyens de suspension décrits dans le document W. Wu et al., "Measurement of Tidal Tilt by a Micromechanical Inertial Sensor Employing Quasi-Zero- Stiffness Mechanism," J. MICROELECTROMECHANICAL Syst., vol. 29, no. 5, p. 10, 2020 peuvent être mis en œuvre.

Comme cela a déjà été expliqué ci-dessus, une largeur d'entrefer le plus faible possible est recherchée. Or les procédés de fabrication ne permettent pas de réduire cette largeur en-dessous d'un rapport 20 par rapport à l'épaisseur de la couche micrométrique. Ainsi on peut réaliser un entrefer de largeur 1 μm pour une couche micrométrique de 20 μm. Grâce à la déflexion initiale de de la masse et de la génération de force électrostatique la largeur de l'entrefer est réduite au repos.

Il est à noter que dans l'utilisation d'un accéléromètre selon l'invention en tant que gravimètre, il est principalement recherché un capteur sensible et non un capteur présentant une plage de fonctionnement étendue.

Dans un autre exemple de réalisation, les moyens de mesure comportent au moins une jauge piézorésistive, avantageusement deux montées en différentiel. Grâce aux moyens de couplage électrostatique, tout ou partie des contraintes internes sont annulées dans la ou les jauges, voire la ou les jauges sont mises sous tension. Tous les exemples décrits ci-dessus peuvent mettre en œuvre un ou des jauges piézorésistives à la place de la ou des poutres vibrantes.

Le capteur de force selon l'invention peut être utilisé dans d'autres applications, par exemple telles qu'un magnétomètre mettant en œuvre un matériau magnétique ou des lignes de courant, ou un capteur de pression dans lequel le corps d'épreuve est une membrane. Tous les exemples décrits ci-dessus dans leur application à un accéléromètre s'appliquent à tout autre capteur de force.

Il sera compris que les exemples de réalisation ne sont pas limitatifs. D'autres moyens de suspension peuvent être mis en œuvre pour guider en translation les masses et d'autres configurations d'articulation pivot peuvent être également prévues.

Il sera également compris que les moyens de couplage électrostatique comportant des peignes interdigités peuvent s'appliquer à une masse sismique mobile en rotation.

En outre dans les exemples de réalisation, la ou les poutres vibrantes ou la ou les jauges piézorésistives est ou sont alignée(s) avec la direction de déplacement de la masse sismique mobile en translation, toute autre orientation est envisageable, par exemple en utilisant des moyens de renvoi. Dans les exemples mettant en œuvre des bras de levier, les poutres vibrantes ou les jauges piézorésistives peuvent être orientées orthogonalement à la poutre formant charnière.

En outre les poutres vibrantes ou les jauges piézorésistives et/ou les chariots peuvent être reliés aux bras de levier dans des emplacements autres que les extrémités de ceux-ci. Les capteurs de force selon l'invention peuvent être réalisés par les procédés de la microélectronique, en particulier de la technologie MEMS&NEMS bien connus de l'homme du métier mettant en œuvre des étapes de dépôt et gravure.

Les procédés de fabrication sont tels que les poutres vibrantes ou les jauges piézorésistives sont fabriquées dans une couche nanométrique et les moyens de couplage électrostatique et la masse sismique sont réalisés dans un empilement de couches nanométriques et micrométriques. Les surfaces en regard des moyens de couplage électrostatique sont définies en partie par l'épaisseur des moyens de couplage qui est de dimension micrométrique.

**Revendications**

1. Capteur de force comportant un support (2), au moins un corps d'épreuve (4) suspendu par des moyens de suspension par rapport au support, et apte à se déplacer dans un plan parallèle au support, des moyens de mesure (8) du déplacement du corps d'épreuve (4) comportant au moins une première jauge de contrainte munie d'une poutre vibrante (10), le capteur comprenant en outre des premiers moyens de couplage électrostatique (C1, C3') entre le corps d'épreuve (4) et ladite au moins une première jauge de contrainte (10) configurés pour assurer un découplage mécanique entre ladite première jauge de contrainte (10) et le corps d'épreuve (4), pour qu'au repos, lesdits premiers moyens de couplage électrostatique (C1) génèrent une traction sur la première jauge de contrainte (10), et pour que sous l'effet d'une force extérieure modifient l'état de contrainte de la première jauge de contrainte (10), la poutre vibrante (10) étant de section nanométrique et comprise entre plusieurs dizaines de nanomètres et 1 micromètre, la poutre vibrante (10) étant suspendue par une extrémité audit support (2) et par une autre extrémité à une poutre de suspension (12, 214, 114', 114, 314), la poutre de suspension (12, 214, 114', 114) ayant une section au moins dix fois supérieure à la section de la poutre vibrante (10), la poutre de suspension ayant une section micrométrique comprise entre 1 μm et plusieurs centaines de micromètres.

2. Capteur de force selon la revendication 1, comportant une deuxième jauge de contrainte de section nanométrique (10') montée en différentiel par rapport à la première jauge de contrainte (10), et des deuxièmes moyens de couplage électrostatique (C1') entre le corps d'épreuve (4) et ladite deuxième jauge de contrainte (10') configurés pour assurer un découplage mécanique entre ladite deuxième jauge de contrainte (10') et le corps d'épreuve (4), pour qu'au repos, lesdits deuxièmes moyens de couplage électrostatique (C1') génèrent une traction sur la deuxième jauge de contrainte (10'), et pour que sous l'effet d'une accélération modifient l'état de contrainte de la deuxième jauge de contrainte (10').

**3.** Capteur de force selon la revendication 1 ou 2, dans lequel les premiers (C1) et/ou deuxièmes (C1') moyens de couplage électrostatique sont configurés pour générer, au repos, une force électrostatique de sorte à au moins annuler les contraintes résiduelles dans la première jauge de contrainte (10) et/ou la deuxième jauge de contrainte (10').

**4.** Capteur de force selon la revendication 1 à 3, dans lequel les premiers (C1) moyens de couplage électrostatique comprennent ladite poutre de suspension (12, 214, 114', 114, 314), de sorte qu'un couplage électrostatique est réalisé entre la poutre de suspension et le corps d'épreuve (4).

**5.** Capteur de force selon la revendication 1 à 4, dans lequel les premiers (C1) moyens de couplage électrostatique comportent au moins une première et une deuxième électrode en regard, la première électrode étant formée par un côté du corps d'épreuve (4) et la deuxième électrode étant formée par une face latérale de ladite poutre de suspension (12, 214, 114', 114, 314) fixée à une extrémité longitudinale de la poutre vibrante (10).

**6.** Capteur de force selon l'une des revendications 1 à 4, dans lequel ladite poutre de suspension forme un bras de levier et est articulée en rotation dans le plan du capteur, le bras de levier étant en couplage électrostatique avec le corps d'épreuve.

**7.** Capteur de force selon l'une des revendications 1 à 3, dans lequel les premiers moyens de couplage électrostatique comportent chacun au moins une paire de peignes interdigités munis de doigts, un peigne étant solidaire en mouvement du corps d'épreuve et l'autre étant fixé à un bras de levier formé par ladite poutre de suspension.

**8.** Capteur de force selon l'une des revendications 1 à 7, dans lequel le corps d'épreuve (4) et les moyens de suspension (6) du corps d'épreuve (4) sont configurés pour que le corps d'épreuve (4) se déplace en translation dans le plan le long d'une direction donnée (X).

**9.** Capteur de force selon la revendication 1, dans lequel les premiers moyens de couplage électrostatique comportent un chariot portant au moins un peigne et connecté mécaniquement à un bras de levier formé par ladite poutre de suspension.

**10.** Capteur de force selon la revendication 9, dans lequel le chariot a une masse réduite par rapport à celle du corps d'épreuve, la masse du chariot étant au moins 10 fois inférieure à la masse du corps d'épreuve.

**11.** Capteur de force selon la revendication 9 ou 10, dans lequel le chariot comporte un cadre extérieur délimité par des montants desquels des doigts du peigne font saillie, et dans lequel le au moins un peigne solidaire en mouvement du corps d'épreuve est disposé à l'intérieur du cadre et ses doigts sont placés entre les doigts du peigne du chariot.

**12.** Capteur de force selon la revendication 9, 10 ou 11, comportant plusieurs paires de peignes interdigités de sorte à offrir une surface de couplage électrostatique importante.

**13.** Capteur de force selon la revendication 6, comportant une articulation pivot par laquelle le corps d'épreuve est suspendu au support et au moyen de laquelle le corps d'épreuve est mobile en rotation dans le plan du capteur de force, et dans lequel les premiers et/ou les deuxièmes moyens de couplage sont formés par une face latérale de la poutre de suspension formant le bras de levier et un bord en regard du corps d'épreuve.

**14.** Accéléromètre comportant un capteur de force selon l'une des revendications précédentes, dans lequel le corps d'épreuve est une masse sismique.

**15.** Gravimètre comportant au moins un accéléromètre selon la revendication 14 et dans lequel les moyens de suspension de la masse sismique sont configurés pour flamber lorsque la masse sismique est soumise au 1g de l'accélération terrestre.

**Patentansprüche**

**1.** Kraftsensor mit einem Träger (2), mindestens einem Prüfkörper (4), der mit Aufhängungsmitteln in Bezug auf den Träger aufgehängt ist und in der Lage ist, sich in einer Ebene parallel zum Träger zu bewegen, Messmitteln (8) für die Bewegung des Prüfkörpers (4), die mindestens einen ersten Dehnungsmessstreifen umfassen, der mit einem Schwingbalken (10) versehen ist, wobei der Sensor ferner erste Mittel für die elektrostatische Kopplung (C1, C3') zwischen dem Prüfkörper (4) und dem mindestens einen ersten Dehnungsmessstreifen (10) umfasst, die so eingerichtet sind, dass sie eine mechanische Entkopplung zwischen dem ersten Dehnungsmessstreifen (10) und dem Prüfkörper (4) gewährleisten, damit im Ruhezustand die ersten elektrostatischen Kopplungsmittel (C1) eine Zugkraft auf den ersten Dehnungsmessstreifen (10) erzeugen und damit unter der Wirkung einer äußeren Kraft der Spannungszustand des ersten Dehnungsmessstreifens (10) verändert wird, wobei der Schwingbalken (10) einen nanometrischen Querschnitt von mehreren Dutzend Nanometern bis 1 Mikrometer aufweist, wobei der Schwingbalken (10) mit einem Ende an dem Träger (2) und mit einem anderen Ende an einem Aufhängungsbalken (12, 214, 114', 114, 314) aufgehängt ist, wobei der Aufhängungsbalken (12, 214, 114', 114) einen Querschnitt aufweist, der mindestens zehnmal größer als der Querschnitt des Schwingbalkens (10) ist, wobei der Aufhängungsbalken einen mikrometrischen Querschnitt zwischen 1 μm und mehreren hundert Mikrometern aufweist.

2. Kraftsensor nach Anspruch 1, mit einem zweiten Dehnungsmessstreifen (10') mit nanometrischen Querschnitt, der in Bezug auf den ersten Dehnungsmessstreifen (10) differenziell montiert ist, und zweiten elektrostatischen Kopplungsmitteln (C1') zwischen dem Prüfkörper (4) und dem zweiten Dehnungsmessstreifen (10'), die so eingerichtet sind, dass sie eine mechanische Entkopplung zwischen dem zweiten Dehnungsmessstreifen (10') und dem Prüfkörper (4) gewährleisten, damit im Ruhezustand die zweiten elektrostatischen Kopplungsmittel (C1') eine Zugkraft auf den zweiten Dehnungsmessstreifen (10') erzeugen und damit unter der Wirkung einer Beschleunigung den Spannungszustand des zweiten Dehnungsmessstreifens (10') verändert wird.

3. Kraftsensor nach Anspruch 1 oder 2, wobei die ersten (C1) und/oder zweiten (C1') elektrostatischen Kopplungsmittel so eingerichtet sind, dass sie im Ruhezustand eine elektrostatische Kraft erzeugen, so dass die Restspannungen in dem ersten Dehnungsmessstreifen (10) und/oder dem zweiten Dehnungsmessstreifen (10') mindestens aufgehoben werden.

4. Kraftsensor nach Anspruch 1 bis 3, wobei die ersten (C1) elektrostatischen Kopplungsmittel den Aufhängungsbalken (12, 214, 114', 114, 314) umfassen, so dass eine elektrostatische Kopplung zwischen dem Aufhängungsbalken und dem Prüfkörper (4) erfolgt.

5. Kraftsensor nach Anspruch 1 bis 4, wobei die ersten (C1) elektrostatischen Kopplungsmittel mindestens eine erste und eine zweite gegenüberliegende Elektrode aufweisen, wobei die erste Elektrode von einer Seite des Prüfkörpers (4) gebildet ist und die zweite Elektrode von einer Seitenfläche des Aufhängungsbalkens (12, 214, 114', 114, 314) gebildet ist, der an einem Längsende des Schwingbalkens (10) befestigt ist.

6. Kraftsensor nach einem der Ansprüche 1 bis 4, wobei der Aufhängungsbalken einen Hebelarm bildet und in der Ebene des Sensors drehbar angelenkt ist, wobei der Hebelarm elektrostatisch mit dem Prüfkörper gekoppelt ist.

7. Kraftsensor nach einem der Ansprüche 1 bis 3, wobei die ersten elektrostatischen Kopplungsmittel jeweils mindestens ein Paar ineinandergreifende, mit Zinken versehene Kämme umfassen, wobei ein Kamm bewegungsmäßig fest mit dem Prüfkörper verbunden ist und der andere an einem Hebelarm befestigt ist, der durch den Aufhängungsbalken gebildet wird.

8. Kraftsensor nach einem der Ansprüche 1 bis 7, wobei der Prüfkörper (4) und die Aufhängungsmittel (6) des Prüfkörpers (4) so eingerichtet sind, dass sich der Prüfkörper (4) in Translation in der Ebene entlang einer bestimmten Richtung bewegt (X).

9. Kraftsensor nach Anspruch 1, wobei die ersten elektrostatischen Kopplungsmittel einen Wagen umfassen, der mindestens einen Kamm trägt und mechanisch mit einem Hebelarm verbunden ist, der von dem Aufhängungsbalken gebildet wird.

10. Kraftsensor nach Anspruch 9, wobei der Wagen eine im Vergleich zur Masse des Prüfkörpers reduzierte Masse aufweist, wobei die Masse des Wagens mindestens das 10-Fache der Masse des Prüfkörpers beträgt.

11. Kraftsensor nach Anspruch 9 oder 10, wobei der Wagen einen äußeren Rahmen aufweist, der durch Ständer begrenzt ist, aus denen die Zinken des Kamms hervorstehen, und wobei der mindestens eine mit dem Prüfkörper in Bewegung verbundene Kamm innerhalb des Rahmens angeordnet ist und seine Zinken zwischen den Zinken des Kamms des Wagens platziert sind.

12. Kraftsensor nach Anspruch 9, 10 oder 11, der mehrere Kammpaare umfasst, die so verzahnt sind, dass sie eine große elektrostatische Kopplungsfläche bieten.

13. Kraftsensor nach Anspruch 6, mit einem Drehgelenk, über das der Prüfkörper an dem Träger aufgehängt ist und mittels dessen der Prüfkörper in der Ebene des Kraftsensors drehbar ist, und wobei die ersten und/oder zweiten Kopplungsmittel durch eine den Hebelarm bildende Seitenfläche des Aufhängungsbalkens und eine dem Prüfkörper zugewandte Kante gebildet werden.

14. Beschleunigungsmesser mit einem Kraftaufnehmer nach einem der vorhergehenden Ansprüche, wobei der Prüfkörper eine seismische Masse ist.

15. Gravimeter mit mindestens einem Beschleunigungsmesser nach Anspruch 14, wobei die Aufhängungsmittel der seismischen Masse so eingerichtet sind, dass sie flackern, wenn die seismische Masse 1 g der Erdbeschleunigung ausgesetzt ist.

## Claims

1. Force sensor comprising a support (2), at least one test body (4) which is suspended by suspension means from the support, and which is capable of moving in a plane parallel to the support, means (8) for measuring the displacement of the test body (4), which means comprise at least a first strain gauge provided with a vibrating beam (10), the sensor further comprising first electrostatic coupling means (C1, C3') for electrostatically coupling the test body (4) and said at least one first strain gauge (10), which coupling means are configured to mechanically uncouple said first strain gauge (10) and the test body (4), so that at rest, said first electrostatic coupling means (C1) generate traction on the first strain gauge (10), and so that, under the effect of an external force, said first electrostatic coupling means modify the state of strain of the first strain gauge (10), the vibrating beam (10) having a nanometric cross-section between several tens of nanometres and 1 micrometre, the vibrating beam (10) being suspended, at one end, from said support (2), and at another end, from a suspension beam (12, 214, 114', 114, 314), the suspension beam (12, 214, 114', 114) having a cross-section that is at least ten times greater than the cross-section of the vibrating beam (10), the suspension beam having a micrometric cross-section between 1μm and several hundred micrometres.

2. Force sensor according to claim 1, comprising a second strain gauge of nanometric cross-section (10') with increased differential relative to the first strain gauge (10), and second electrostatic coupling means (C1') for electrostatically coupling the test body (4) and said second strain gauge (10'), which coupling means are configured to mechanically uncouple said second strain gauge (10') and the test body (4), so that at rest, said second electrostatic coupling means (C1') generate traction on the second strain gauge (10'), and so that under the effect of acceleration, the state of strain of the second strain gauge (10') is modified.

3. Force sensor according to claim 1 or 2, wherein the first (C1) and/or second (C1') electrostatic coupling means are configured to generate, at rest, an electrostatic force so as to at least cancel the unrecovered strain in the first strain gauge (10) and/or the second strain gauge (10').

4. Force sensor according to claims 1 to 3, wherein the first electrostatic coupling means (C1) comprise said suspension beam (12, 214, 114', 114, 314), such that an electrostatic coupling is produced between the suspension beam and the test body (4).

5. Force sensor according to claims 1 to 4, wherein the first electrostatic coupling means (C1) comprise at least a first and a second electrode facing one another, the first electrode being formed by a side of the test body (4) and the second electrode being formed by a side face of said suspension beam (12, 214, 114', 114, 314) attached to a longitudinal end of the vibrating beam (10).

6. Force sensor according to one of claims 1 to 4, wherein said suspension beam forms a lever arm and is rotatably articulated in the plane of the sensor, the lever arm being electrostatically coupled with the test body.

7. Force sensor according to one of claims 1 to 3, wherein the first electrostatic coupling means each comprise at least one pair of interdigitated combs with fingers, one comb being rigidly connected to the test body to move as one therewith, and the other comb being attached to a lever arm formed by said suspension beam.

8. Force sensor according to one of claims 1 to 7, wherein the test body (4) and the suspension means (6) of the test body (4) are configured so that the test body (4) translates in the plane in a given direction (X).

9. Force sensor according to claim 1, wherein the first electrostatic coupling means comprise a carriage carrying at least one comb and mechanically connected to a lever arm formed by said suspension beam.

10. Force sensor according to claim 9, wherein the carriage has a lower mass than the test body, the mass of the carriage being at least 10 times less than the mass of the test body.

11. Force sensor according to claim 9 or 10, wherein the carriage comprises an outer frame defined by uprights from which fingers of the comb project, and wherein the at least one comb rigidly connected to the test body to move as one therewith is arranged inside the frame and its fingers are placed between the fingers of the comb of the carriage.

12. Force sensor according to claim 9, 10 or 11, comprising a plurality of pairs of interdigitated combs so as to provide a large electrostatic coupling surface.

13. Force sensor according to claim 6, comprising a pivot joint via which the test body is suspended from the support and by means of which the test body is rotatable in the plane of the force sensor, and wherein the first and/or the second coupling means are formed by a side face of the suspension beam forming the lever arm and an edge facing the test body.

14. Accelerometer comprising a force sensor according to one of the preceding claims, wherein the test body is a seismic mass.

15. Gravimeter comprising at least one accelerometer according to claim 14 and wherein the suspension means of the seismic mass are configured to buckle when the seismic mass is subjected to 1g of the Earth's acceleration.

FIG.1A

FIG.1B

FIG.2

FIG.3A

FIG.3B

FIG.4A

FIG.4B

FIG.4C

FIG.4D

FIG.4E

FIG.5

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **BRUNO BARAZANI**. *Microfabricated Neuroaccelerometer: Integrating Sensing and Reservoir Computing in MEMS*
- **W. WU et al.** Measurement of Tidal Tilt by a Micromechanical Inertial Sensor Employing Quasi-Zero-Stiffness Mechanism. *J. MICROELECTROMECHANICAL Syst*, 2020, vol. 29 (5), 10
- **W. WU et al.** Measurement of Tidal Tilt by a Micromechanical Inertial Sensor Employing Quasi-Zero-Stiffness Mechanism. *J. MICROELECTROMECHANICAL Syst.*, 2020, vol. 29 (5), 10